Europäisches Patentamt

European Patent Office

Office européen des brevets

(11) Veröffentlichungsnummer: **0 206 191**
A2

# (12) EUROPÄISCHE PATENTANMELDUNG

(21) Anmeldenummer: **86108173.5**

(51) Int. Cl.⁴: **H 03 J 5/24**

(22) Anmeldetag: **14.06.86**

(30) Priorität: **25.06.85 DE 3522652**

(43) Veröffentlichungstag der Anmeldung: **30.12.86**
**Patentblatt 86/52**

(84) Benannte Vertragsstaaten: **AT DE FR IT**

(71) Anmelder: **Blaupunkt-Werke GmbH,**
**Robert-Bosch-Strasse 200, D-3200 Hildesheim (DE)**

(72) Erfinder: **Nikolaou, Michael, Comblouxstrasse 1,**
**D-3201 Diekholzen (DE)**

(74) Vertreter: **Eilers, Norbert, Dipl.-Phys., Blaupunkt-Werke**
**GmbH Robert-Bosch-Strasse 200, D-3200 Hildesheim**
**(DE)**

(54) **Schaltungsanordnung zur Abstimmung von Empfängern.**

(57) Bei einer Schaltungsanordnung zur Abstimmung eines Empfängers, insbesondere eines Fernsehempfängers, mit einem Oszillator, einem Vorkreis und einem Bandfilter, welche jeweils mit Hilfe von Kapazitätsvariations-Dioden durchstimmbar sind, sind den Kapazitätsvariations-Dioden Kondensatoren zugeordnet, denen zur Umschaltung des Empfangsbereichs weitere Kondensatoren mittels Schaltdioden zuschaltbar sind. Die weiteren Kondensatoren sind im Vorkreis und im Bandfilter in Reihe mit den Kondensatoren geschaltet und im Oszillator mit dem Kondensator parallelgeschaltet.

BLAUPUNKT-WERKE GMBH, 3200 Hildesheim

Schaltungsanordnung zur Abstimmung von Empfängern

Die Erfindung geht aus von einer Schaltungsanordnung nach der Gattung des Hauptanspruchs.

Es sind schon Schaltungsanordnungen zur Abstimmung von Empfängern bekannt, bei welchen jeweils ein Oszillator, ein Vorkreis und ein Bandfilter mit Hilfe von Kapazitätsvariations-Dioden durchstimmbar sind. Die Kapazitätsvariations-Dioden werden dabei in Sperrichtung mit einer einstellbaren Gleichspannung beaufschlagt, wodurch ihre Kapazität verändert werden kann. Insbesondere bei der Verwendung der bekannten Schaltungsanordnungen für einen großen Frequenzbereich, wie er beispielsweise bei einer Empfangseinrichtung für den Empfang der Fernsehbereiche I und III benötigt wird, treten bezüglich der Übereinstimmung der Abhängigkeit zwischen der Frequenz und der zugeführten Steuerspannung beim Oszillator, beim Vorkreis und beim Bandfilter Schwierigkeiten auf.

...

R.-Nr. 1871　　　　- 2 -　　　　

Aufgabe der vorliegenden Erfindung ist es eine Schaltungsanordnung zur Abstimmung von Empfängern anzugeben, bei welcher ein möglichst genauer Gleichlauf zwischen den einzelnen frequenzbestimmenden Gliedern erzielt wird.

Die erfindungsgemäße Schaltungsanordnung mit den kennzeichnenden Merkmalen des Hauptanspruchs hat den Vorteil, daß zwischen dem Oszillator, dem Vorkreis und dem Bandfilter beim Durchstimmen ein sehr guter Gleichlauf besteht. Des weiteren trägt die erfindungsgemäße Anordnung zu einer Verstärkungslinearisierung, einer Verringerung des Rauschens und einer Verbesserung der Selektion bei.

Durch die in den Unteransprüchen aufgeführten Maßnahmen sind vorteilhafte Weiterbildungen und Verbesserungen der im Hauptanspruch angegeben Schaltungsanordnung möglich.

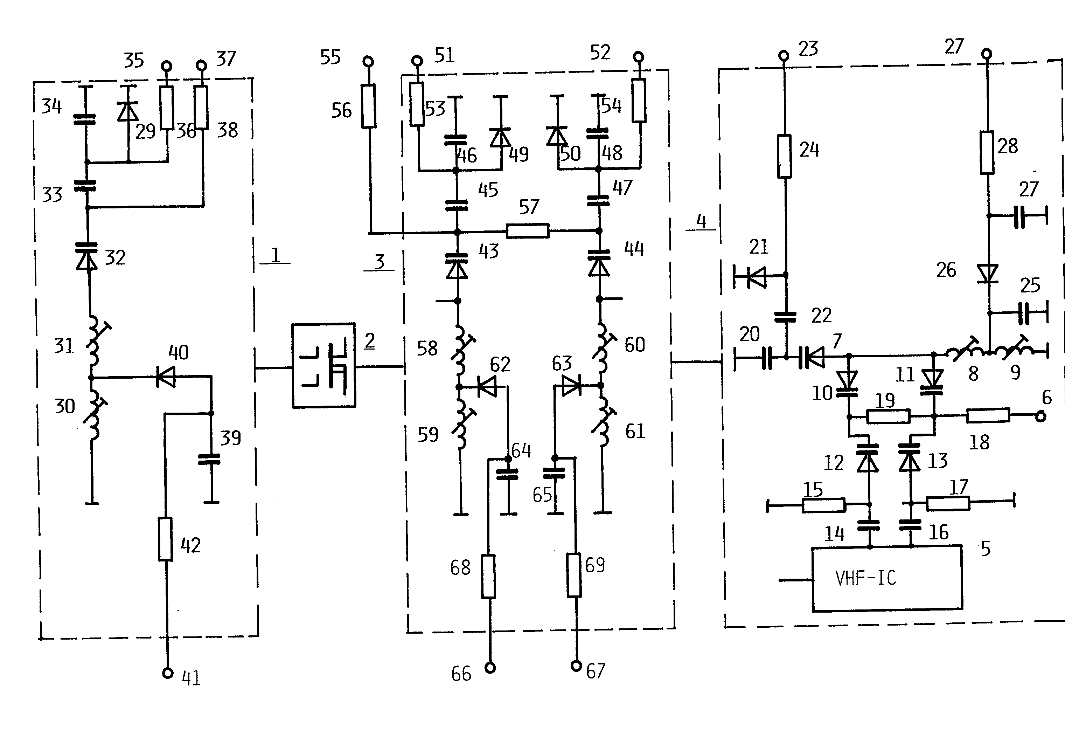

Ein Ausführungsbeispiel der Erfindung ist in der Zeichnung dargestellt und in der nachfolgenden Beschreibung näher erläutert.

In der Zeichnung sind die für das Verständnis der Erfindung erforderlichen Teile eines VHF-Tuners dargestellt. Der VHF-Tuner besteht im wesentlichen aus einem Vorkreis 1, einem rauscharmen Vorverstärker 2, einem Bandfilter 3 und einem Oszillator 4. Der Oszillator 4 umfaßt einen an sich bekannten integrierten Schaltkreis 5 und ein durchstimmbares frequenzbestimmendes Netzwerk, welchem bei 6 eine Abstimmspannung zuführbar ist. Zum Empfang eines Frequenzbereichs von 46 bis 134 MHz schwingt der Oszillator 4 mit

...

R.-Nr. 1871      - 3 -     

einer Frequenz, welche oberhalb der Empfangsfrequenz liegt. Zum Empfang im Bereich von 116,7 bis 304 MHz schwingt der Oszillator mit einer Frequenz, welche niedriger als die Empfangsfrequenz ist.

Der aus der Kapazitätsvariations-Diode 7 und den Induktivitäten 8 und 9 bestehende Oszillatorkreis ist mit Hilfe der Kapazitätsvariations-Dioden 10, 11, 12, 13 und den R/C-Gliedern 14, 15 und 16, 17 an den integrierten Schaltkreis 5 angekoppelt. Die Abstimmspannung wird über den Eingang 6 und die Widerstände 18 und 19 den Kapazitätsvariations-Dioden zugeführt.

In Reihe mit der Kapazitätsvariations-Diode 7 ist ein Kondensator 20 angeordnet. Diesem kann über die Diode 21 ein weiterer Kondensator 22 parallelgeschaltet werden. Die Diode 21 befindet sich im leitenden Zustand, wenn ihrer Anode über den Eingang 23 und den Widerstand 24 eine positive Spannung zugeführt wird. Diese ist der Fall beim Empfang innerhalb des oberen Teils des Frequenzbereichs (VHF-Bereich III), wenn der Oszillator unterhalb der Empfangsfrequenz schwingt.

Für den Empfang innerhalb des unteren Teils des Frequenzbereichs (VHF-Bereich I) wird dem Eingang 23 eine negative Spannung zugeführt, so daß die Diode 21 gesperrt ist und der Oszillator oberhalb der Empfangsfrequenz schwingt.

Der Induktivität 9 ist ein Kondensator 25 parallelgeschaltet, welchem über die Diode 26 ein weiterer Kondensator 27 zugeschaltet werden kann. Durch Anlegen einer positiven Spannung an den Eingang 27 wird

...

R.-Nr. 1871          - 4 -          0206191

die Anode der Diode 26 über den Widerstand 28 mit positiver Spannung beaufschlagt und daher in den leitenden Zustand geschaltet, so daß der Kondensator 27 zugeschaltet wird. Liegt am Eingang 27 eine negative Spannung an, so ist allein der Kondensator 25 wirksam.

Bei dem Vorkreis 1 besteht das frequenzbestimmende Glied aus den Induktivitäten 30 und 31 sowie aus der Kapazitätsvariations-Diode 32, welche in Reihe mit den zwei Kondensatoren 33 und 34 geschaltet ist. Zum Empfang im oberen Teil des Frequenzbereichs (VHF-Bereich III) wird dem Eingang 35 eine Spannung von etwa 0 V zugeführt, damit ist die Diode 29, deren Anode über den Widerstand 36 mit dem Eingang 35 verbunden ist, nichtleitend, so daß die Reihenschaltung der Kondensatoren 33 und 34 wirksam ist. Der Vorkreis ist dann auf eine höhere Frequenz ausgelegt, deren Abstimmung durch die über den Eingang 37 und den Widerstand 38 zugeführte Abstimmspannung erfolgt.

In ähnlicher Weise wie bei dem Oszillator 1 wird beim Empfang im VHF-Bereich III der Induktivität 30 ein Kondensator 39 über die Diode 40 parallelgeschaltet, wozu über den Eingang 41 und den Widerstand 42 der Anode der Diode 40 eine positive Spannung zugeführt wird. Beim Empfang im VHF-Bereich I liegt am Eingang 41 negatives Potential, so daß die Diode 40 gesperrt ist.

Im Bandfilter 3 sind zwei miteinander gekoppelte Schwingkreise vorgesehen, welche grundsätzlich dem Vorkreis 1 entsprechen. In Reihe mit den Kapazitätsvariations-Dioden 43 und 44 sind Kondensatoren 45,

...

R.-Nr. 1871          - 5 -

46 und 47, 48 geschaltet, von denen jeweils die Kondensatoren 46 und 48 mit Hilfe je einer Diode 49 und 50 überbrückbar sind. Zur Umschaltung zwischen VHF-Bereich I und VHF-Bereich III wird eine entsprechende Steuerspannung über die Eingänge 51 und 52 und über die Widerstände 53 und 54 zugeführt. Die Abstimmung erfolgt mit Hilfe der über den Eingang 55 und die Widerstände 56 und 57 zugeleiteten Abstimmspannung. Die Induktivitäten 58, 59 und 60, 61 sind wiederum zweigeteilt. Der mit Masse verbundene Teil ist jeweils mit Hilfe der Dioden 62 und 63 mit je einem Kondensator 64 und 65 überbrückbar. Entsprechende Schaltspannungen werden über die Eingänge 66, 67 und die Widerstände 68, 69 zugeführt.

Mit der erfindungsgemäßen Schaltungsanordnung lassen sich ganz besonders gute Ergebnisse erzielen, wenn für die Dioden 21, 26, 29, 49, 50, 36 induktivitätsarme Schaltdioden, beispielsweise sogenannte Mini-Melf-Dioden, verwendet werden. Ferner hat sich die Anwendung von Chip-Bauteilen bewährt. Das sind elektronische Bauteile, wie beispielsweise Widerstände und Kondensatoren, die direkt auf die Leiterbahnen gelötet werden.

R.-Nr. 1871

BLAUPUNKT-WERKE GMBH, 3200 Hildesheim

Patentansprüche

1. Schaltungsanordnung zur Abstimmung eines Empfängers, insbesondere eines Fernsehempfängers, mit einem Oszillator, einem Vorkreis und einem Bandfilter, welche jeweils mit Hilfe von Kapazitätsvariations-Dioden durchstimmbar sind, wobei den Kapazitätsvariations-Dioden Kondensatoren zugeordnet sind, dadurch gekennzeichnet, daß den Kondensatoren (20, 33, 45, 47) zur Umschaltung des Empfangsbereichs weitere Kondensatoren (22, 34, 46, 48) zuschaltbar sind.

2. Schaltungsanordnung nach Anspruch 1, dadurch gekennzeichnet, daß die weiteren Kondensatoren (22, 34, 46, 48) im Vorkreis (1) und im Bandfilter (3) in Reihe mit den Kondensatoren (33, 45, 47) liegen und im Oszillator (4) mit dem Kondensator (20) parallelgeschaltet sind.

3. Schaltungsanordnung nach Anspruch 2, dadurch gekennzeichnet, daß im Vorkreis (1) und im Bandfilter (3) die weiteren Kondensatoren (34, 46, 48) mit elektronischen Schaltern (29, 49, 50) zum

...

Empfang in einem Bereich niedrigerer Frequenz (VHF-Bereich I) überbrückbar sind und daß im Oszillator (4) in Reihe mit dem weiteren Kondensator (22) ein weiterer elektronischer Schalter (21) angeordnet ist, welcher beim Empfang im Bereich niedrigerer Frequenz (VHF-Bereich I) nichtleitend ist.

4. Schaltungsanordnung nach Anspruch 3, dadurch gekennzeichnet, daß die elektronischen Schalter (21, 29, 49, 50) von Dioden gebildet sind, denen über je einen Widerstand (24, 36, 53, 54) ein Schaltsignal zuführbar ist.

5. Schaltungsanordnung nach Anspruch 4, dadurch gekennzeichnet, daß die Dioden (21, 29, 49, 50) induktivitätsarme Schaltdioden, insbesondere Mini-Melf-Dioden, sind.

6. Schaltungsanordnung nach Anspruch 1, dadurch gekennzeichnet, daß die frequenzbestimmenden Induktivitäten im Oszillator, im Vorkreis und im Bandfilter zweigeteilt sind und daß jeweils dem einen Teil über einen elektronischen Schalter (26, 40, 62, 63) ein Parallelkondensator (27, 39, 64, 65) zuschaltbar ist und daß im Oszillator zusätzlich ein fester Parallelkondensator (25) angeordnet ist.

0206191
R.-Nr. 1871
1/1

VHF-IC